**Europäisches Patentamt**

**European Patent Office**

**Office européen des brevets**

(19)

(11) Numéro de publication: **0 230 820
B1**

(12)

# FASCICULE DE BREVET EUROPEEN

(45) Date de publication du fascicule du brevet:
**07.11.90**

(51) Int. Cl.⁵: **H01L 21/28**, H01L 29/10

(21) Numéro de dépôt: **86402824.6**

(22) Date de dépôt: **16.12.86**

(54) **Procédé de réalisation d'éclectrodes alignées par rapport à un niveau d'implantation dans un substrat et procédé de réalisation d'un filtre à transfert de charges.**

(30) Priorité: **20.12.85 FR 8518987**

(43) Date de publication de la demande:
**05.08.87 Bulletin 87/32**

(45) Mention de la délivrance du brevet:
**07.11.90 Bulletin 90/45**

(84) Etats contractants désignés:
**DE GB NL**

(56) Documents cités:
**US-A- 3 897 282
US-A- 4 026 733
US-A- 4 065 847
US-A- 4 086 609**

(73) Titulaire: **THOMSON-CSF, 51, Esplanade du Général de Gaulle, F-92800 Puteaux(FR)**

(72) Inventeur: **Beal, Gérard, THOMSON-CSF
SCPI 19, avenue de Messine, F-75008 Paris(FR)**
Inventeur: **Blanchard, Pierre, THOMSON-CSF
SCPI 19, avenue de Messine, F-75008 Paris(FR)**

(74) Mandataire: **Lepercque, Jean et al, THOMSON-CSF
SCPI, F-92045 PARIS LA DEFENSE CEDEX 67(FR)**

**Description**

L'invention concerne un procédé de réalisation sur un substrat d'électrodes alignées par rapport à un niveau d'implantation réalisé dans le substrat. Elle est particulièrement applicable à la réalisation de dispositifs à transfert de charges et elle concerne également un procédé de réalisation d'un filtre à transfert de charge.

La plupart des implantations ioniques utilisant de la résine photosensible pour masquer les zones implantées doivent être alignées avec d'autres niveaux. Ces implantations ne peuvent se faire que par l'intermédiaire de masques réalisées antérieurement ce qui ne permet pas une grande précision d'alignement.

En effet, dans certains dispositifs, une zone d'un substrat a subi une implantation ionique et la zone implantée est recouverte par une électrode avec une précision qui est difficile à obtenir par les procédés connus.

Notamment, dans certains dispositifs tels que le dispositif à transfert de charge décrit dans le document US 4 086 609 des électrodes sont fractionnées de façon à scinder le paquet de charges transféré. On peut alors réaliser un filtrage transversal. Cependant, un tel dispositif pour être efficace doit avoir des électrodes positionnées avec précision par rapport aux zones dopées.

L'invention concerne un procédé permettant de résoudre un tel problème.

L'invention concerne donc un procédé de réalisation d'électrodes recouvrant de façon alignée un niveau d'implantation dans un substrat comportant les étapes successives suivantes:

a) une première phase de réalisation d'une première couche d'un matériau diélectrique sur un substrat;

b) une deuxième phase de réalisation sur la première couche de matériau diélectrique d'une deuxième couche d'un matériau semiconducteur ou conducteur;

c) une troisième phase d'enlèvement du matériau semiconducteur ou conducteur dans des premières zones où doivent être réalisées des implantations, de part et d'autre d'au moins une deuxième zone où est maintenu le matériau semiconducteur ou conducteur;

d) une quatrième phase d'implantation du substrat dans lesdites premières zones;

e) une cinquième phase de réalisation d'une troisième couche de matériau semiconducteur ou conducteur sur les premières zones du substrat et sur le matériau semiconducteur ou conducteur de la deuxième zone;

f) une sixième phase de découpe dans la troisième couche de matériau semiconducteur ou conducteur et dans la deuxième couche de matériau semiconducteur ou conducteur perpendiculairement au plan de ces couches de façon à obtenir des électrodes séparées par un espace se trouvant dans la deuxième zone.

L'invention concerne également un procédé de réalisation d'un filtre à transfert de charges selon lequel:

– la zone où est maintenu le matériau semiconducteur ou conducteur à l'issue de la troisième phase d'enlèvement, est orientée selon un premier axe parallèle à la surface du substrat et possède selon cet axe au moins un rétrécissement et un élargissement;

– la découpe d'électrodes de la sixième phase comporte la découpe d'au moins une première électrode orientée perpendiculaire à l'axe et chevauchant une portion du rétrécissement et de deux demi-électrodes espacées l'une de l'autre et orientée dans le prolongement l'une de l'autre parallèlement à la première électrode, chaque demi-électrode empiétant sur l'élargissement;

– il comporte, à la suite de la sixième phase, une septième phase de réalisation d'une quatrième couche d'un matériau diélectrique suivie d'une huitième phase de réalisation d'une cinquième couche d'un matériau semi-conducteur ou conducteur, puis d'une neuvième phase de découpe dans la cinquième couche de matériau semi-conducteur ou conducteur d'électrodes parallèles aux électrodes découpées lors de la sixième phase et chevauchant chacune deux de ces électrodes de la sixième phase ou une électrode et deux demi-électrodes.

Les différents objets et caractéristiques de l'invention apparaîtront plus clairement dans la description qui va suivre faite à titre d'exemple en se reportant aux figures annexées qui représentent:

– les figures 1 à 7, différentes étapes d'un exemple du procédé de réalisation d'électrodes alignées par rapport à un niveau d'implantation dans un substrat selon l'invention ;

– les figures 8 à 13, différentes étapes d'un exemple du procédé de réalisation, selon l'invention, d'un filtre à transfert de charges.

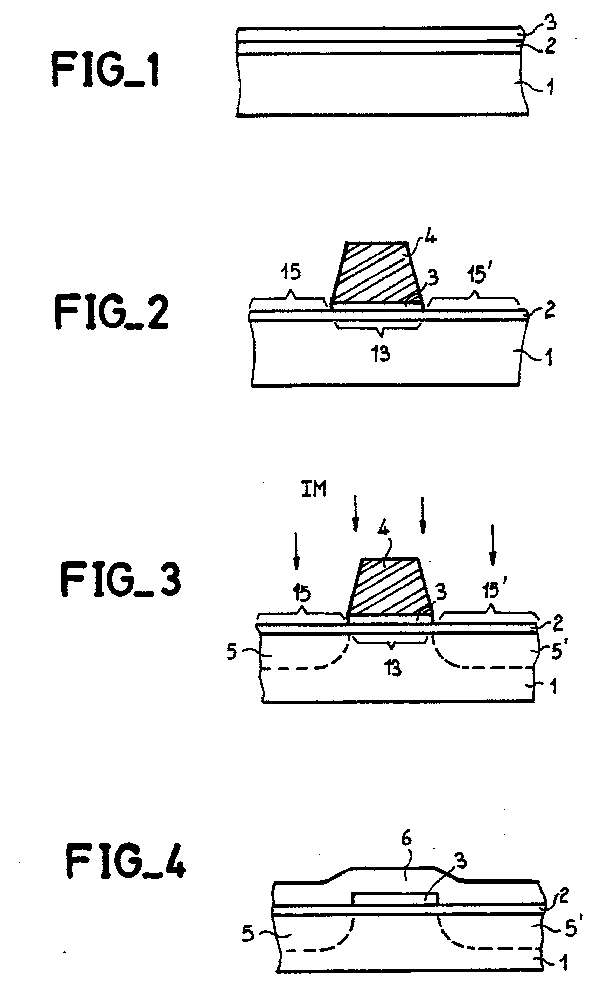

En se reportant aux figures 1 à 7, on va tout d'abord décrire un exemple de procédé de réalisation d'alignement d'électrodes par rapport à une zone d'implantation sous-jacente.

Dans le cas le plus courant, il s'agit d'aligner des zones implantées avec des électrodes réalisées en silicium polycristallin.

Selon une première phase du procédé de l'invention, on réalise sur un substrat semi-conducteur 1 une première couche 2 d'un matériau diélectrique.

Au cours d'une deuxième phase, représentée en figure 1, on réalise une deuxième couche 3 d'un matériau semi-conducteur ou conducteur tel que du silicium polycristallin.

Au cours d'une troisième phase on réalise le retrait du matériau semi-conducteur de la couche 3 dans les zones où doit être effectuée une implantation ionique. La présente phase est réalisée, par exemple, par photolithogravure et est représentée en figure 2 où on trouve, à titre d'exemple, un plot 4 en matériau photosensible qui a permis par photolithogravure d'éliminer le matériau semi-conducteur non protégé par ce plot 4. On a ainsi défini deux zones 15 et 15' qui ne sont plus recouvertes par la couche de matériau semi-conducteur 3 et une zone 13 recouverte par la couche de matériau semi-conducteur 3.

Au cours d'une quatrième phase, on réalise une implantation ionique telle que représentée sur la figure 3 par les flèches IM. Les zones 15 et 15' subissent cette implantation tandis que la zone 13 est protégée par la couche de matériau semi-conducteur 3. Des zones 5 et 5' du substrat 1, sous-jacentes aux zones 15 et 15' sont ainsi implantées. Le plot 4 de matériau photosensible est ensuite supprimé par des moyens connus dans la technique de photolithogravure.

Au cours d'une cinquième phase on réalise comme représenté en figure 4 une couche 6 d'un matériau semi-conducteur ou conducteur tel que du silicium polycristallin.

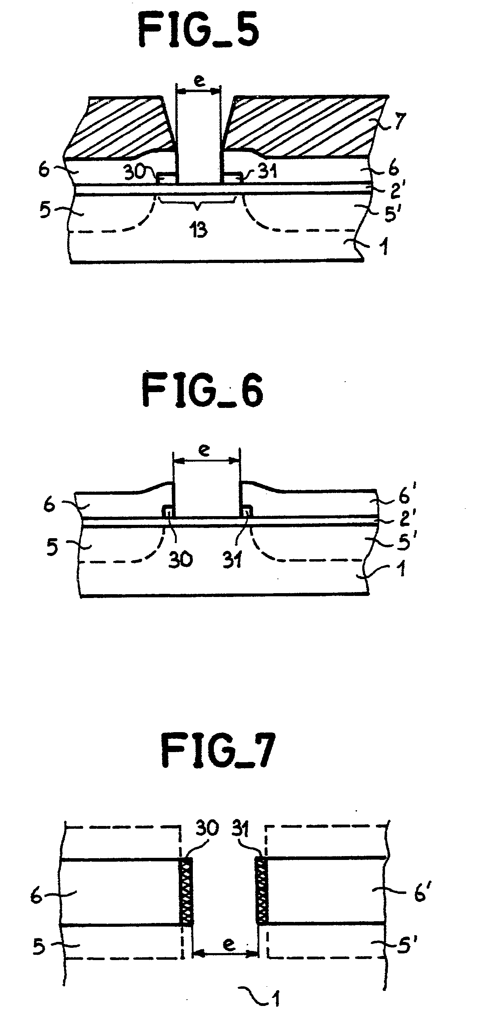

Enfin, au cours d'une sixième phase, on réalise par photolithogravure, à l'aide d'une couche 7 d'un matériau photosensible, une gravure d'électrodes 6 et 6' dans la couche de matériau semi-conducteur précédemment déposée. La couche 7 de matériau photosensible laisse libre un espace e situé à l'emplacement de la zone 13 comportant le matériau semi-conducteur de la couche 3. Ainsi, la photolithogravure permet également d'attaquer le matériau semi-conducteur de la couche 3. Selon la figure 5, cette photolithogravure laisse subsister des portions 30 et 31 de la couche 3 et les deux électrodes obtenues sont constituées respectivement d'une couche 6 et d'une portion 30 de matériau semi-conducteur d'une part et, d'autre part d'une couche 6' et d'une portion 31 de matériau semi-conducteur.

L'espace e peut être choisi et situé de façon à éliminer quasi entièrement les portions 30 et 31 de la couche 3. On obtient alors des électrodes 6 et 6' qui recouvrent pratiquement avec précision des zones implantées 5 et 5'.

Après élimination de la couche photo-sensible 7, on obtient, comme représenté en figure 6 et en figure 7, qui représente une vue de dessus de la figure 6, un substrat 1 comportant deux zones 5 et 5' ayant subi une implantation ionique. Deux électrodes 6 et 6' recouvrant partiellement ces zones implantées. L'espace e existant entre les électrodes 6 et 6' peut être augmenté de façon à diminuer l'importance des portions 30 et 31. Ainsi, les bords en vis-à-vis des électrodes 6 et 6' peuvent coïncider avec les limites des zones implantées 5 et 5' et on obtient des électrodes 6 et 6' alignées avec les implantations 5 et 5'.

D'une manière générale, on utilise pour la couche 3, servant de masquage pour l'implantation, un matériau de même nature que celui utilisé pour réaliser la couche 6.

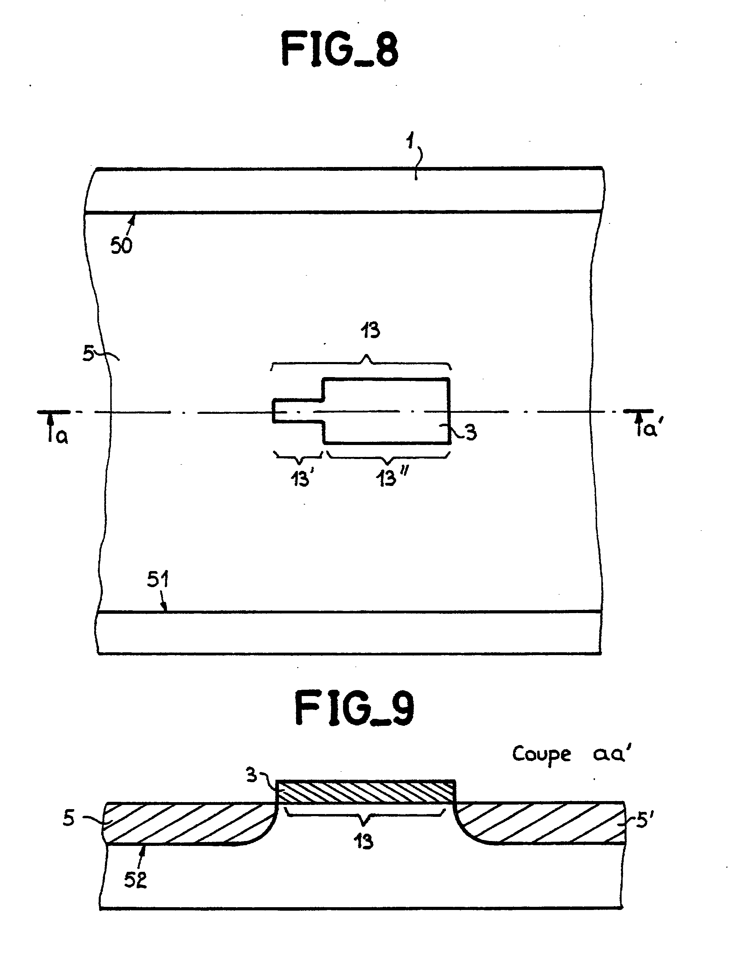

En se reportant aux figures 8 à 13, on va décrire un procédé de réalisation d'un filtre à transfert de charge mettant en application le procédé décrit précédemment.

En effet, l'une des applications envisageables de ce procédé est la réalisation des coefficients d'un filtre à transferts de charges à pondération fixe.

Les coefficients sont généralement définis par la technique dite des électrodes coupées qui permet à chaque étage du registre à décalage à transfert de charge, de scinder le paquet de charges transféré en deux, permettant par une méthode de lecture non destructive de pondérer ce paquet de charge (image d'un échantillon du signal) aux instants n TH (TH étant la période de transfert) donc de réaliser après sommation la fonction de filtrage transversal.

Il est nécessaire dans le cas de technologies à géométries faibles de pouvoir aligner correctement les parties des électrodes définissant le coefficient de pondération par rapport au canal de transfert du registre et plus particulièrement par rapport à l'absence de canal qui permet d'une part l'isolation des deux paquets de charge entre eux et d'autre part de réaliser un prépartage au niveau de l'électrode précédente.

Pour une meilleure définition du coefficient et un transfert correct à fréquence élevée cette absence de canal doit être de très petites géométries et parfaitement positionnée par rapport au premier niveau de silicium polycristallin définissant les électrodes et ceci dans les deux axes.

Dans cette application, le fait de pouvoir positionner le premier niveau de silicium polycristallin par rapport au niveau d'implantation définissant le canal du registre est primordial si on veut réduire les géométries, d'où l'intérêt du procédé de l'invention.

On va donc maintenant décrire un procédé de réalisation d'un tel filtre à transfert de charges en se référant aux différentes phases du procédé décrit précédemment.

Comme représenté en figures 8 et 9, on réalise à l'aide des première, deuxième et troisième phases précédentes, un plot 3 en silicium polycristallin recouvrant une zone 13. Selon le procédé de réalisation de l'invention, ce plot possède une partie rétrécie et une partie élargie alignées selon un axe aa', déterminant pour la zone 13 une partie rétrécie 13' et une partie élargie 13".

Au cours de la quatrième phase du procédé de l'invention, l'implantation ionique s'opère dans le substrat 1 non recouvert par le plot en matériau semi-conducteur ou conducteur 3 et est limité sur la figure 8 à sa partie supérieure, selon une ligne 50, et à sa partie inférieure selon une ligne 51.

Sur la figure 9, l'implantation ionique est réalisée dans des zones 5 et 5' séparées par la zone 13 et limitée en profondeur selon un ligne 52.

Selon une cinquième phase non représentée, on réalise ensuite une couche d'un matériau semi-conducteur ou conducteur. Cette couche peut être réalisée avec un matériau de même nature que celui du plot 3, mais il peut être également de nature différente. Notamment, dans le cas de silicium, le premier dépôt peut être du silicium polycristallin, le deuxième dépôt du Tantale, par exemple, pour former après recuit un silicium de Tantale.

Selon une sixième phase, on découpe dans la précédente couche et dans le plot 3 des électrodes 6, 16, 26, 31 parallèles entre elles et perpendiculaires à l'axe aa'.

Une électrode 6, par exemple, empiète sur le rétrécissement 13' correspondant à la zone 13 de la figure 1. Une électrode voisine recouvrant partiellement l'élargissement 13" est réalisée en deux demi-électrodes 16 et 16' séparées par un espace d orienté selon l'axe bb'. Les demi-électrodes empiètent sur l'élargissement 13″ de la zone 13.

D'autres électrodes telles que 26 et 36 peuvent être réalisées.

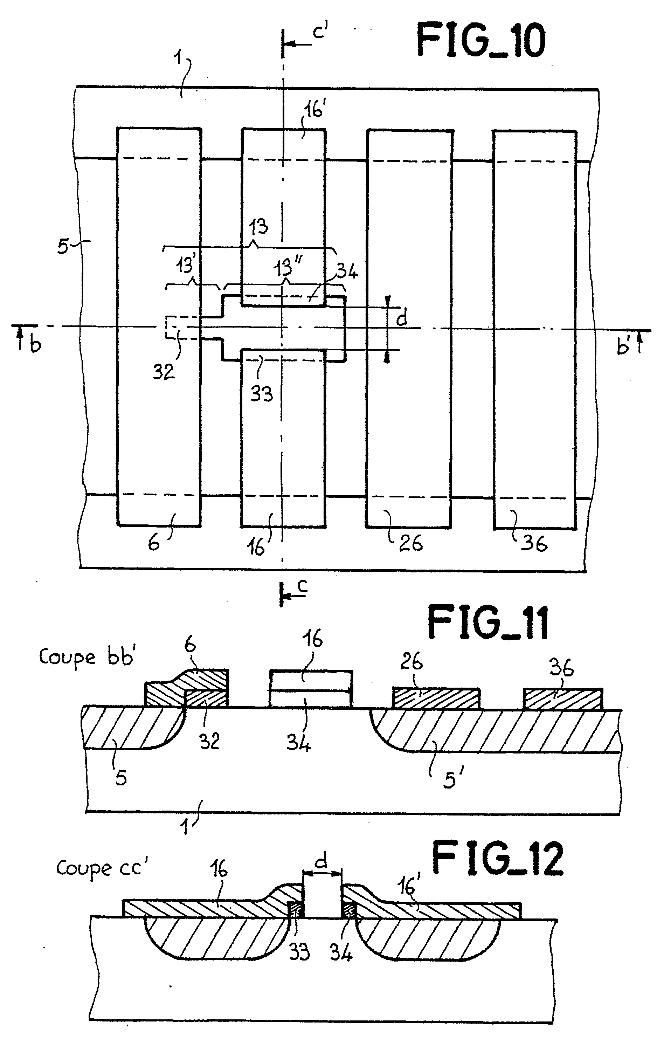

Comme représenté sur les figures 11 et 12, on obtient donc au moins :
- une électrode 6 recouvrant partiellement le rétrécissement 13' et comportant alors une portion 32 de plot 3 ;
- une première demi-électrode 16 recouvrant partiellement l'élargissement 13″ et comportant une portion 33 du plot 3 ;
- une deuxième demi-électrode 16' recouvrant également partiellement l'élargissement 13″ en vis-à-vis de la première demi-électrode 16 et comportant une portion 34 du plot 4.

Les différentes électrodes obtenues recouvrent l'implantation ionique réalisée précédemment.

Les chevauchements des électrodes sur la zone 3 peuvent être réduits au maximum et de ce fait, les portions 32, 33, 34 du plot 3 également.

Au cours d'une septième phase, on réalise une couche d'un matériau diélectrique non représentée sur les figures.

Au cours d'une huitième phase, on réalise une couche d'un matériau semi-conducteur ou conducteur.

Enfin, au cours d'une neuvième phase, on découpe dans la couche de matériau semi-conducteur ou conducteur de la huitième phase, et ce jusqu'au diélectrique de la septième phase, des électrodes 7, 17, 27, 37.

Ces électrodes 7, 17, 27, 37 sont disposées parallèlement aux électrodes et demi-électrodes 6, 16, 16', 26 réalisées précédemment, et en quinconce par rapport à ces électrodes, de façon à recouvrir les espaces entre ces électrodes selon l'axe bb'.

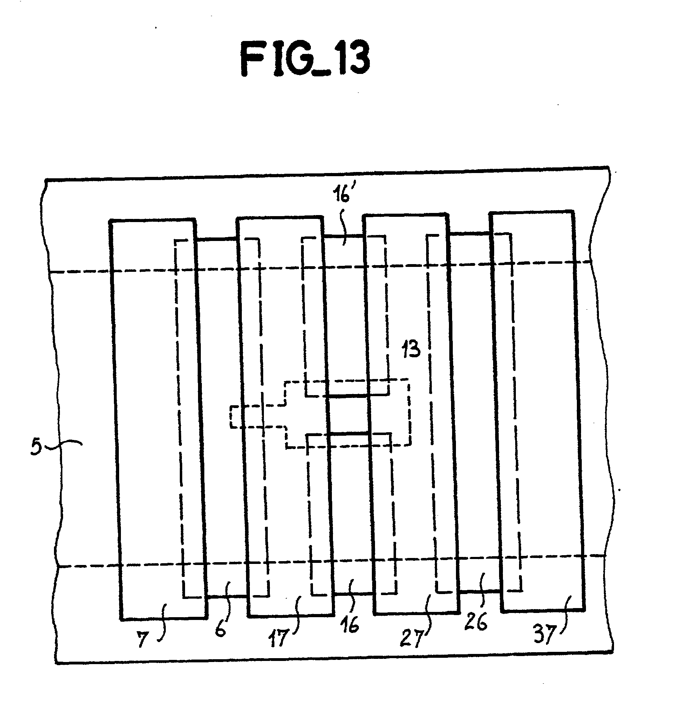

On obtient ainsi un filtre à transfert de charges tel que représenté en figure 13.

Sur cette figure, la zone ayant subi une implantation ionique est représentée par un trait pointillé court, la zone 13 n'étant pas implantée.

Les premières électrodes réalisées 6, 16, 16', 26 sont représentées en un trait pointillé long pour leurs parties qui sont cachées par les électrodes réalisées au cours de la neuvième phase.

Les deuxièmes électrodes réalisées 7, 17, 27, 37 sont représentées en trait continu fort.

Il est bien évident que les descriptions des procédés qui précèdent n'ont été faites qu'à titre d'exemple.

Les formes des électrodes et demi-électrodes 6 à 36 et 7 à 37 ainsi que de la zone 13 et du plot 3 peuvent être différentes sans sortir du cadre de l'invention.

Les dimensions de la zone non implantée ainsi que des dimensions des espaces entre les électrodes et entree les demi-électrodes seront choisies en fonction des applications spécifiques à réaliser sans qu'elles constituent une limite à la présente invention.

## Revendications

1. Procédé de réalisation d'électrodes recouvrant de façon alignée un niveau d'implantation dans un substrat, comportant des étapes successives suivantes:

a) une première phase de réalisation d'une première couche d'un matériau diélectrique (2) sur un substrat (1);

b) une deuxième phase de réalisation sur la première couche de matériau diélectrique (2), d'une deuxième couche d'un matériau semi-conducteur ou conducteur (3);

c) une troisième phase d'enlèvement du matériau semi-conducteur ou conducteur (3) dans des premières zones (15, 15') où doivent être réalisées des implantations, de part et d'autre d'au moins une deuxième zone (13) où est maintenu le matériau semiconducteur ou conducteur (3);

d) une quatrième phase d'implantation (5, 5') du substrat (1) dans lesdites premières zones (15, 15');

e) une cinquième phase de réalisation d'une troisième couche de matériau semiconducteur ou conducteur (6) sur les premières zones (15, 15') du substrat (1) et sur le matériau semiconducteur ou conducteur (3) de la deuxième zone (13);

f) une sixième phase de découpe dans la troisième couche de matériau semi-conducteur ou conducteur (6) et dans la deuxième couche de matériau semi-conducteur (3) perpendiculairement au plan de ces couches (6 et 3) de façon à obtenir des électrodes (6, 6') séparées par une espace (e) se trouvant dans la deuxième zone (13).

2. Procédé selon la revendication 1, caractérisé en ce que la troisième phase d'enlèvement du matériau semiconducteur ou conducteur (3) se fait par photolithogravure.

3. Procédé selon la revendication 1, caractérisé en ce que la sixième phase de découpe se fait par photolithogravure.

4. Procédé selon la revendication 1, caractérisé en ce que la deuxième couche de matériau semiconducteur ou conducteur (3) et la troisième couche de matériau semiconducteur ou conducteur (6) sont de même nature.

5. Procédé de réalisation d'une filtre à transfert de charge selon l'une quelconque des revendications précédentes selon lequel:

— la zone (13) où est maintenu le matériau semiconducteur ou conducteur (3) à l'issue de la troisième phase d'enlèvement, est orientée selon un premier axe (bb') parallèle à la surface du substrat et possède selon cet axe au moins un rétrécissement (13') et un élargissement (13″);

— la découpe d'électrodes de la sixième phase comporte la découpe d'au moins une première électrode (6) orientée perpendiculaire à l'axe (bb') et chevauchant une portion (32) du rétrécissement (13') et de deux demi-électrodes (16, 16') espacées l'une de l'autre et orientée dans le prolongement l'une de l'autre parallèlement à la première électrode, chaque demi-électrode (16, 16') empiétant sur l'élargissement (13″);

— il comporte, à la suite de la sixième phase, une septième phase de réalisation d'une quatrième couche d'un matériau diélectrique suivie d'une huitième phase de réalisation d'une cinquième couche d'un matériau semiconducteur ou conducteur, puis d'une neuvième phase de découpe dans la cinquième couche de matériau semiconducteur ou conducteur d'électrodes (7, 17, 27, 37) parallèles aux électrodes découpées lors de la deuxième phase ou une électrode (6) et deux demi-électrodes (16, 16').

## Claims

1. A method for producing electrodes which cover, in an aligned manner, an implantation level in a substrate the method comprising the following successive phases:
a) a first phase of producing a first layer of a dielectric material (2) on a substrate (1),
b) a second phase of producing a second layer of semiconducting or conducting material (3) on the first layer of dielectric material (2),
c) a third phase of removing the semiconducting or conducting material (3) from first areas (15, 15') wherein implantations are to be effected, on both sides of at least one second area (13), wherein the semiconducting or conducting material (3) is maintained,
d) a fourth phase of implanting (5, 5') the substrate (1) within said first areas (15, 15'),
e) a fifth phase of producing a third layer of semiconducting or conducting material (6) on the first areas (15, 15') of the substrate (1) and on the semiconducting or conducting material (3) of the second area (13),
f) a sixth phase of performing cuttings in the third layer of semiconducting or conducting material (6) and in the second layer of semiconducting or conducting material (3) perpendicularly to the plane of these layers (6 and 3), so as to obtain electrodes (6, 6') which are spaced apart by an interspace (e) located in the second area.
2. A method according to claim 1, characterized in that the third phase of removing the semiconducting or conducting material (3) is performed by photolithography.
3. A method according to claim 1, characterized in that the sixth phase of cutting is performed by photolithography.
4. A method according to claim 1, characterized in that the second layer of semiconducting or conducting material (3) and the third layer of semiconducting and conducting material (6) are of the same type.
5. A method for producing a charge transfer filter according to any one of the preceding claims, in which
- the area (13), wherein the semiconducting and the conducting material (3) is maintained at the end of the third phase of removal is oriented along a first axis (bb') disposed parallelly to the surface of the substrate and has at least one narrowed portion (13') and one broadened portion (13") along said axis,
- the cuttings for electrodes during the sixth phase comprise the cutting for at least one first electrode (6) oriented perpendicularly to the axis (bb') and overlapping a part (32) of the narrowed portion (13'), and for two half-electrodes (16, 16') spaced apart from one another and aligned one to the other in parallel to the first electrode, with each demi-electrode (16, 16') projecting into the broadened portion (13"),
- the method includes, subsequent to the sixth phase, a seventh phase of producing a fourth layer of a dielectric material, followed by an eighth phase of producing a fifth layer of a semiconducting or conducting material, and then a nineth phase of forming a cutting in the fifth layer of semiconducting or conducting material for electrodes (7, 17, 27, 37) disposed parallelly to the electrodes cut out during the sixth phase and each overlapping two of these electrodes cut out during the sixth phase or one electrode (6) and two half-electrodes (16, 16').

## Patentansprüche

1. Verfahren zur Herstellung von Elektroden, die in ausgerichteter Weise ein Implantationsniveau in einem Substrat bedecken, wobei das Verfahren die nachstehenden aufeinanderfolgenden Phasen aufweist:
a) in einer ersten Phase die Herstellung einer ersten Schicht aus einem dielektrischen Material (2) auf einen Substrat (1),
b) in einer zweiten Phase die Herstellung einer zweiten Schicht aus einem halbleitenden oder leitenden Material (3) auf der ersten Schicht (2) aus dielektrischem Material,
c) in einer dritten Phase das Entfernen des halbleitenden oder leitenden Materials (3) in ersten Zonen (15, 15'), wo die Implantationen erfolgen sollen, zu beiden Seiten mindestens einer zweiten Zone (13), wo das halbleitende oder leitende Material (3) verbleibt,
d) in einer vierten Phase die Implantation (5, 5') des Substrats (1) in den ersten Zonen (15, 15'),
e) in einer fünften Phase die Herstellung einer dritten Schicht aus halbleitendem oder leitendem Material (6) auf den ersten Zonen (15, 15') des Substrats (1) und auf dem halbleitenden oder leitenden Material (3) der zweiten Zone (13),
f) in einer sechsten Phase das Zerschneiden der dritten Schicht des halbleitenden oder leitenden Materials (6) und der zweiten Schicht des halbleitenden oder leitenden Materials (3) senkrecht zur Ebene dieser Schichten (6 und 3), derart, daß sich Elektroden (6, 6') ergeben, die durch einen Abstand (e) getrennt sind, der sich in der zweiten Zone (13) befindet.
2. Verfahren nach Anspruch 1, dadurch gekennzeichnet, daß in der dritten Phase das Entfernen des halbleitenden oder leitenden Materials (3) durch Photolithograghie erfolgt.
3. Verfahren nach Anspruch 1, dadurch gekennzeichnet, daß in der sechsten Phase das Zerschneiden durch Photolithographie erfolgt.
4. Verfahren nach Anspruch 1, dadurch gekennzeichnet, daß die zweite Schicht aus halbleitendem oder leitendem Material (3) und die dritte Schicht aus halbleitendem oder leitendem Material (6) von der gleichen Art sind.

5. Verfahren zur Herstellung eines Ladungsferfilters nach einem beliebigen der vorhergehenden Ansprüche, bei dem:

- die Zone (13), in der das halbleitende oder leitende Material (3) nach dem Entfernen von Material in der dritten Phase übrigbleibt, in Richtung einer ersten Achse (bb') parallel zur Oberfläche des Substrats orientiert ist und entlang dieser Achse mindestens eine Einschnürung (13') und eine Verbreiterung (13") besitzt,

- das Schneiden von Elektroden während der sechsten Phase mindestens eine erste senkrecht zur Achse (bb') orientierte und einen Abschnitt der Einschnürung (13') überlappende Elektrode (6) und zwei Halbelektroden (16, 16') ergibt, die mit Zwischenabstand und in Flucht zueinander sowie parallel zur ersten Elektrode angeordnet sind, wobei jede Halbelektrode (16, 16') die Verbreiterung überlappt,

- das Verfahren im Anschluß an die sechste Phase eine siebte Phase aufweist, in der eine vierte Schicht aus einem dielektrischen Material erzeugt wird und der eine achte Phase zur Herstellung einer fünften Schicht aus einem halbleitenden Material, und dann eine neunte Phase des Schneidens der fünften Schicht des halbleitenden oder leitenden Materials zur Bildung von Elektroden (7, 17, 27, 37) folgt, die parallel zu den in der sechsten Phase ausgeschnittenen Elektroden liegen und jeweils zwei in der sechsten Phase gebildeten Elektroden oder eine Elektrode (6) und zwei Halbelektroden (16, 16') überlappen.

EP 0 230 820 B1

FIG_1

FIG_2

FIG_3

FIG_4

# FIG_5

# FIG_6

# FIG_7

# FIG_8

# FIG_9

Coupe aa'

# FIG_10

# FIG_11

Coupe bb'

# FIG_12

Coupe cc'

# FIG_13